# EUROPÄISCHE PATENTSCHRIFT

(11) **EP 3 417 499 B1**
(45) Veröffentlichungstag und Bekanntmachung des Hinweises auf die Patenterteilung: **01.04.2020**
(21) Anmeldenummer: 17708693.1
(22) Anmeldetag: 14.02.2017
(51) Int. Cl.: H01M 4/04, H01M 4/1393, H01M 4/1395, H01M 4/36, H01M 4/38, H01M 4/583, H01M 4/60, H01M 10/052, H01M 4/133, H01M 4/134, H01M 4/02

(54) **VERFAHREN ZUR HERSTELLUNG VON SI-C-KOMPOSITPARTIKELN**
METHOD FOR PRODUCING SI-C COMPOSITE PARTICLES
PROCÉDÉ DE FABRICATION DE PARTICULES COMPOSITES SI-C

(30) Priorität: 17.02.2016 DE 102016202458
(43) Veröffentlichungstag der Anmeldung: 26.12.2018
(73) Patentinhaber: Wacker Chemie AG, 81737 München (DE)
(72) Erfinder: TROEGEL, Dennis, 91242 Ottensoos (DE)
(74) Vertreter: Ege, Markus
(86) Internationale Anmeldenummer: PCT/EP2017/053215
(87) Internationale Veröffentlichungsnummer: WO 2017/140645

(56) Entgegenhaltungen:
- DE-A1-102009 033 251
- KR-A- 20150 078 059
- US-A1- 2009 130 562
- US-A1- 2014 057 179
- US-A1- 2015 118 567

## Beschreibung

Die vorliegende Erfindung betrifft Verfahren zur Herstellung von Si/C-Kompositpartikeln, die so erhältlichen Si/C-Kompositpartikel und deren Verwendung als Anodenaktivmaterialien für Lithium-Ionen-Batterien.

Als Speichermedien für elektrischen Strom sind Lithium-Ionen-Batterien gegenwärtig die praxistauglichen elektrochemischen Energiespeicher mit den höchsten Energiedichten. Lithium-Ionen-Batterien werden vor allem im Bereich der tragbaren Elektronik, für Werkzeuge und auch für elektrisch angetriebene Transportmittel, wie Fahrräder oder Automobile, genutzt. Als Material für die negative Elektrode ("Anode") entsprechender Batterien ist gegenwärtig graphitischer Kohlenstoff weit verbreitet. Nachteilig ist jedoch seine relativ niedrige elektrochemische Kapazität von theoretisch höchstens 372 mAh pro Gramm Graphit, die nur etwa einem Zehntel der mit Lithiummetall theoretisch erreichbaren elektrochemischen Kapazität entspricht. Die Entwicklung alternativer Anodenmaterialien führte zu einem Zusatz von Silicium. Silicium bildet mit Lithium binäre elektrochemisch aktive Legierungen, die sehr hohe Lithiumgehalte und beispielsweise für Li_{4.4}Si theoretische spezifische Kapazitäten im Bereich von 4200 mAh pro Gramm Silicium erreichen können.

Nachteiligerweise ist die Ein- und Auslagerung von Lithium in Silicium mit einer sehr starken Volumenänderung verbunden, die etwa 300% erreichen kann. Derartige Volumenänderungen setzen die Kristallite einer starken mechanischen Belastung aus, auf Grund derer die Kristallite schließlich auseinander brechen können. Dieser auch als elektrochemische Mahlung bezeichnete Prozess führt im Aktivmaterial und in der Elektrodenstruktur zu einem Verlust der elektrischen Kontaktierung und damit zur Zerstörung der Elektrode unter Kapazitätsverlust.

Weiterhin reagiert die Oberfläche des Silicium-Anodenmaterials mit Bestandteilen des Elektrolyten unter kontinuierlicher Bildung passivierender Schutzschichten (Solid Electrolyte Interface; SEI), was zu einer Immobilisierung von Lithium führt. Auf Grund der extremen Volumenänderung des Siliciums während des Lade- bzw. Entladevorgangs der Batterie platzt die SEI regelmäßig auf, wodurch weitere Oberflächen des Silicium-Anodenmaterials freigelegt werden, die dann einer weiteren SEI-Bildung ausgesetzt sind, so dass während des Betriebs der Batterie ein kontinuierlicher irreversibler Lithium-Ionen-Verlust resultiert. Da in der Vollzelle die Menge an mobilem Lithium, welches der nutzbaren Kapazität entspricht, durch das Kathodenmaterial begrenzt ist, ist dieses schnell verbraucht und die Kapazität der Zelle sinkt bereits nach wenigen Zyklen in anwendungstechnisch nicht annehmbarem Ausmaß.

Die Abnahme der Kapazität im Laufe mehrerer Lade- und Entladezyklen wird auch als Fading oder kontinuierlicher Kapazitätsverlust bezeichnet und ist in der Regel irreversibel.

Zur Lösung dieser Probleme sind unterschiedlichste Ansätze verfolgt worden, wie beispielsweise beschrieben von A. J. Appleby et al. in J. Power Sources 2007, 163, 1003-1039. Das Si-haltige Aktivmaterial wird üblicherweise als physikalische Mischung mit Graphit (EP 1730800) oder als Si/C-Kompositmaterial in die Elektrodenaktivmaterialien eingesetzt (M. Rossi et al., J. Power Sources 2014, 246, 167-177). In Si/C-Kompositen ist das Silicium in eine Kohlenstoff-Matrix eingelagert.

Für Si/C-Komposite sind unterschiedliche Ausgestaltungsformen beschrieben worden. Beispielsweise sind poröse Si/C-Komposite bekannt, die über das gesamte Material statistisch verteilte Poren enthalten:
Solche Si/C-Komposite sind beispielsweise erhältlich durch thermische Zersetzung von Kohlenstoff-Precursoren unter Bildung von niedrigmolekularen, flüchtigen Zersetzungsprodukten und Poren, wie beispielsweise beschrieben in der WO10006763. Häufig werden der C-Matrix spezielle Porenbildner zugesetzt, die in der Matrix gleichmäßig verteilt werden und sich beim Erhitzen in gasförmige Produkte zersetzen und dabei Poren erzeugen. Etablierte Porenbildner sind Polyethylenglycole, Polyalkylenoxide, Zucker oder anorganische Carbonate, wie beschrieben in CN101847711, WO11006698, US2013045423, JP2006228640 oder von L.-Z. Fan et al in ChemElectroChem 2014, 1, 2124, L. Zhang et al. in J. Mater. Chem. A 2013, 1, 15068 oder Y.-K. Sun et al. in Electrochimica Acta 2011, 58, 578. Auch in US2013130115 sind poröse Kohlenstoff-basierte Materialien beschrieben. Zunächst wurden dabei aus SiO₂-Nanopulver und Pech durch Carbonisieren Komposite aus SiO₂ und Kohlenstoff hergestellt. Dann wurde SiO₂ herausgeätzt und schließlich wurden Metall-Nanostrukturen auf der Oberfläche und in inneren Poren abgeschieden.

Bekannt sind auch Si/C-Komposite, die gleichmäßig über die gesamte C-Matrix verteilte Poren haben und zudem mit einer äußeren Beschichtung versehen sind:
B. Li et al. beschreiben in Electrochem. Comm. 2014, 49, 98 Si/C-Core-Shell-Mikrosphären mit einem kugelförmigen Hohlraum, der durch eine äußere Kohlenstoff-Beschichtung begrenzt ist. Der Hohlraum enthält ein Netzwerk aus Si-Nanopartikeln, welche mit amorphem Kohlenstoff verbunden sind. Die US6770399 beschreibt ein Si/C-Komposit-Partikel, welches im Inneren eine poröse Struktur aus gemahlenen, nanoskaligen Silicium- und Graphit-Partikeln enthält, welche über eine äußere KohlenstoffSchicht, aufgebracht aus Benzoldampf mittels chemischer Gasphasenabscheidung (chemical vapor deposition, CVD), zusammengehalten werden. Die US2013323595 beschreibt ein Substrat, welches nach CVD-Verfahren mit einer graphitischen Kohlenstoff-Beschichtung versehen ist. Die WO14031929 und die US2014057179 offenbaren Komposit-Partikel auf Basis einer Aktivmaterial-Partikel enthaltenden, porösen, leitfähigen Matrix und einer äußeren Beschichtung. Die US20120100438 beansprucht Komposit-Strukturen mit einer Kernstruktur aus porösem Silicium und einer äußeren Beschichtung.

Weiterhin sind auch Verfahren zur Herstellung von porösen Si/C-Kompositen bekannt, in denen Silicium-Nanopartikel in Makroporen eingebettet sind:
Hierzu werden Si-Nanopartikel sehr häufig zunächst mit anorganischen Templaten, wie Siliciumdioxid, und anschließend mit C-Precursoren beschichtet. Die C-Precursoren werden carbonisiert und die anorganischen Template, beispielsweise mit Flusssäure oder Natronlauge, herausgeätzt, wodurch eine Pore um die Si-Partikel gebildet wird. Nachteiligerweise sind hierbei separate Verfahrensschritte für die Umsetzung der C-Precursoren und der Template erforderlich, was zum einen die Herstellkosten erhöht, zum anderen zu einer Komposit-Matrix führt, die nicht flüssigkeitsdicht ist und die Ätzmedien bis an die Si-Partikel heranlässt, wie beispielsweise beschrieben in CN104319401 oder von J. Ahn et al. in J. Phys. Chem. C. 2015, 119, 10255; L.-Z. Fan et al. in Nanoscale 2014, 6, 3138; Z. Sun et al. in J. Electrochem. Soc. 2015, 162, A1530 oder L. Zhang in Electrochimica Acta 2014, 125, 206. Z. Liu et al. erzeugten durch Sprühtrocknen einer Mischung aus Silicium-Nanopartikeln, SiO₂-Nanopulver, Saccharose und einer Kohlenstoffquelle sowie anschließendem Carbonisieren Kompositpartikel, aus denen SiO₂ mittels Flusssäure wieder herausgeätzt wurde (J. Power Sources 2015, 286, 534). Die CN104300125 beansprucht ein Verfahren zur Herstellung von porösen, Granatapfel-analogen Si/C-Kompositen mit definierten Hohlräumen in der C-Matrix, in welchen Si-Nanopartikel eingebettet vorliegen. Auch Y. Cui et al. (Nature Nanotechnology 2014, 9, 187) beschreiben poröse, Granatapfel-artige Si/C-Komposite mit Si-Nanopartikeln in definierten Hohlräumen. In den Verfahren von Cui et al. werden zunächst Si-Nanopartikel mit einer SiO₂-Schicht versehen. Die so erhaltenen Si@SiO₂-Partikel werden zu Clustern aggregiert, die mit einem Kohlenstoff-Precursor beschichtet wurden. Carbonisieren der Kohlenstoff-Precursoren und anschließendes Herausätzen der SiO₂-Schicht ergab die porösen Si/C-Komposite. Auf Grund des Ätzschrittes sind die Si/C-Komposite gegenüber flüssigen Medien zwangsläufig nicht dicht. Dies zeigt sich auch daran, dass sich die eingebetteten Si-Nanopartikel durch eine wässrige Natronlauge vollständig aus den porösen Si/C-Kompositen herausätzen lassen (siehe Nature Nanotechnology 2014, 9, 187; Supplementary Information).

Auch Ansätze zur Beschichtung von Si/C-Kompositen, die Silicium-Partikel in Porenräumen enthalten, sind vereinzelt beschrieben:
Die WO2015051309 beansprucht poröse Si/C-Komposite mit Granatapfel-Struktur, wie in Y. Cui et al. (Nature Nanotechnology 2014, 9, 187) beschrieben. Des Weiteren offenbart WO2015051309 das Aufbringen einer äußeren leitfähigen Beschichtung (beispielsweise aus Kupfer) auf die porösen Si/C-Komposite, wodurch die Leitfähigkeit der porösen Si/C-Komposite gesteigert werden soll.

Vor diesem Hintergrund bestand die Aufgabe, effizientere Verfahren zur Herstellung von Si/C-Kompositpartikeln bereitzustellen. Dabei sollten die Si/C-Kompositpartikel aufgebaut sein aus einer Siliciumpartikel enthaltenden Kohlenstoff-Matrix und einer Beschichtung um die Kohlenstoff-Matrix, wobei Siliciumpartikel gezielt in Poren der Kohlenstoff-Matrix eingebettet sein sollen. Die Herstellung der Kohlenstoff-Matrix und das gezielte Einbetten von Siliciumpartikeln in Poren der Kohlenstoff-Matrix sollten in einer Stufe erfolgen.
Die so erhältlichen Si/C-Kompositpartikel sollten bei Einsatz in Lithiumionen-Batterien vorteilhafte anwendungstechnische Eigenschaften haben, wie beispielsweise eine hohe Zyklenbeständigkeit bei Lade- und Entladevorgängen, insbesondere eine möglichst geringe SEI-Bildung oder ein reduziertes elektrochemisches Mahlen. Auch sollten die Siliciumpartikel in den Si/C-Kompositpartikeln durch eine hohe Leitfähigkeit für Lithiumionen bzw. durch eine hohe elektrische Leitfähigkeit charakterisiert sein.

Gegenstand der Erfindung sind Verfahren zur Herstellung von Si/C-Kompositpartikeln durch
a) Beschichten von Siliciumpartikeln mit einem oder mehreren organischen oder anorganischen Opfermaterialien ausgewählt aus der Gruppe umfassend Oxide, Carbonate, Carbide, Nitride oder Sulfide der Elemente Magnesium, Calcium, Zinn, Zink, Titan oder Nickel; Polyethylen; Polypropylen; Polystyrol; Polybutadien; Poly-tert-Butoxystyrol; Polyvinylchlorid; Polyvinylacetat; Polymethacrylmethacrylat; Polyacrylsäure; Polymethacrylat; Polyvinylstearat; Polyvinyllaurat; Polyvinylalkohol; Alkylenglycole; Polyalkylenoxide; Gamma-Butyro lacton; Propylencarbonat; Polyurethane; und Stickstoff-haltige Lösungsmittel,
b) Beschichten der Produkte aus Stufe a) mit einem oder mehreren organischen Kohlenstoff-Precursoren, ausgewählt aus der Gruppe umfassend Resorcin-Formaldehyd-Harz, Lignin und Polyacrylnitril, unter Bildung von Präkompositen,
c) thermische Behandlung der Präkomposite aus Stufe b), wobei die in Stufe b) hergestellte Beschichtung basierend auf organischen Kohlenstoff-Precursoren carbonisiert und das organische oder anorganische Opfermaterial aus den Präkompositen teilweise oder vollständig freigesetzt wird unter Bildung von porösen Kompositen und
d) Beschichten der porösen Komposite aus Stufe c) mit einer oder mehreren Kohlenstoff-Beschichtungen, was zu den Si/C-Kompositpartikeln führt.

Ein weiterer Gegenstand der Erfindung sind die nach dem vorgenannten Verfahren erhältlichen Si/C-Kompositpartikel, mit der Maßgabe, dass sich ≥ 80% der Siliciumpartikel, bezogen auf die Gesamtzahl der Siliciumpartikel, in Poren der porösen Komposite der Stufe c) befinden (Bestimmungsmethode: Raster-Elektronen-Mikroskopie).

Durch die thermische Behandlung in Stufe c) werden die Opfermaterialien freigesetzt und die organischen Kohlenstoff-Precursoren carbonisiert, wobei in Folge dieses Prozessschritts Siliciumpartikel im Allgemeinen an die carbonisierten organischen Kohlenstoff-Precursoren bzw. an die so entstandenen porösen Komposite angebunden werden und die Siliciumpartikel abgesehen von dieser Anbindungsstelle im Allgemeinen von einem Hohlraum umgeben sind beziehungsweise sich in einer Pore befinden. Vorzugsweise wird jeder Siliciumpartikel in eine Pore eingebettet. Solche Poren entstehen in Stufe c) durch das Freisetzen von Opfermaterial aus dem Präkomposit. In Folge der erfindungsgemäßen Verfahrensschritte befinden sich die Siliciumpartikel in Poren und sind zudem an das in Stufe c) gebildete poröse Komposit angebunden. Die Anbindung ist im Allgemeinen lokal, so dass der weitaus größte Teil der Oberfläche der Siliciumpartikel von dem Hohlraum umgeben ist. Die Anbindung erfolgt im Allgemeinen über amorphen Kohlenstoff. An der Anbindungsstelle sind das poröse Komposit beziehungsweise der amorphe Kohlenstoff mit dem Siliciumpartikel im Allgemeinen über chemische, insbesondere kovalente Bindungen, oder physikalische Wechselwirkungen verknüpft. Diese Ausgestaltung der Si/C-Kompositpartikel erwies sich als besonders vorteilhaft zur Lösung der erfindungsgemäßen Aufgabe, insbesondere in Hinblick auf die Leitfähigkeit bei Einsatz der Si/C-Kompositpartikel in Lithiumionen-Batterien. Die Leitfähigkeit solcher Si/C-Kompositpartikel kann beispielsweise ≥ 0,1 S/m, bevorzugt ≥ 20 S/m, besonders bevorzugt ≥ 200 S/m und am meisten bevorzugt ≥ 400 S/m betragen und damit beispielsweise in der Größenordnung etablierter Leitadditive, wie Leitruß (∼420 S/m), liegen. Diese Eigenschaft äußert sich auch elektrochemisch in einer guten Nutzung des Aktivmaterials von beispielsweise ≥ 80%, bevorzugt ≥ 90% und besonders bevorzugt ≥ 95% der theoretischen Kapazität.

Die Siliciumpartikel sind vorzugsweise nicht aggregiert, vorzugsweise nicht agglomeriert und/oder vorzugsweise nicht nanostrukturiert.

Aggregiert bedeutet, dass sphärische oder weitestgehend sphärische Primärpartikel, wie sie beispielsweise zunächst in Gasphasenprozessen bei der Herstellung der Siliciumpartikel gebildet werden, im weiteren Reaktionsverlauf des Gasphasenprozesses zusammenwachsen und auf dies Weise Aggregate bilden. Diese Aggregate können im weiteren Reaktionsverlauf Agglomerate bilden. Agglomerate sind eine lose Zusammenballung von Aggregaten. Agglomerate können mit typischerweise eingesetzten Knet- oder Dispergierverfahren leicht wieder in die Aggregate aufgespalten werden. Aggregate lassen sich mit diesen Verfahren nicht oder nur teilweise in die Primärpartikel zerlegen. Das Vorliegen von Siliciumpartikeln in Form von Aggregaten oder Agglomeraten kann beispielsweise mittels herkömmlicher Raster-Elektronen-Mikroskopie (REM) sichtbar gemacht werden. Statische Lichtstreuungsmethoden zur Bestimmung der Teilchengrößenverteilungen oder Partikeldurchmessern von Siliciumpartikeln können dagegen nicht zwischen Aggregaten oder Agglomeraten unterscheiden.

Nicht nanostrukturierte Siliciumpartikel haben im Allgemeinen charakteristische BET-Oberflächen. Die BET-Oberflächen der Siliciumpartikel betragen vorzugsweise 0,01 bis 30,0 m²/g, mehr bevorzugt 0,1 bis 25,0 m²/g, besonders bevorzugt 0,2 bis 20,0 m²/g und am meisten bevorzugt 0,2 bis 18,0 m²/g. Die BET-Oberfläche wird gemäß DIN 66131 (mit Stickstoff) bestimmt.

Die Siliciumpartikel können beispielsweise in kristalliner oder amorpher Form vorliegen und sind vorzugsweise nicht porös. Die Siliciumpartikel sind vorzugsweise sphärisch oder splitterförmige Partikel. Alternativ, aber weniger bevorzugt können die Siliciumpartikel auch eine Faserstruktur haben oder in Form von Silicium-haltigen Filmen oder Beschichtungen vorliegen.

Die Siliciumpartikel sind im Allgemeinen submikro- oder nanoskalig. Siliciumpartikel weisen volumengewichtete Partikelgrößenverteilungen mit Durchmesser-Perzentilen d₅₀ von vorzugsweise ≥ 50 nm, mehr bevorzugt ≥ 80 nm, besonders bevorzugt ≥ 100 nm und am meisten bevorzugt ≥ 150 nm auf. Die genannten Durchmesser-Perzentile d₅₀ sind vorzugsweise ≤ 800 nm, besonders bevorzugt ≤ 400 nm und am meisten bevorzugt ≤ 200 nm.

Die volumengewichtete Partikelgrößenverteilung ist bestimmbar nach ISO 13320 mittels statischer Laserstreuung unter Anwendung des Mie-Modells mit dem Messgerät Horiba LA 950 mit Ethanol als Dispergiermedium für die Siliciumpartikel.

Die Siliciumpartikel können beispielsweise auf elementarem Silicium, Siliciumoxid oder Silicium/Metall-Legierungen basieren. Bevorzugt ist elementares Silicium, da dieses die größte Speicherkapazität für Lithium-Ionen aufweist.

Die Siliciumpartikel können bevorzugt aus hochreinem Polysilicium, aber auch gezielt dotiertem Silicium oder metallurgischem Silicium bestehen, welches elementare Verunreinigung aufweisen kann. Weiterhin kann es mit anderen Metallen und Elementen legiert in Form von Siliciden vorliegen, z.B. mit literaturbekannten Metallen wie Li, Sn, Ca, Co, Ni, Cu, Cr, Ti, Al, Fe u.a. Diese Legierungen können binär, ternär oder multinär vorliegen. Zur Erhöhung der elektrochemischen Speicherkapazität ist ein besonders niedriger Gehalt an Fremdelementen bevorzugt.

Die Oberfläche der Siliciumpartikel kann chemisch modifiziert sein. Typische Oberflächenfunktionalitäten können sein: Si-H, Si-Cl, Si-OH, Si-OAlkyl, Si-OAryl, Si-Alkyl, Si-Aryl, Si-OSilyl. Besonders bevorzugt sind Oberflächengruppen, die physikalisch oder chemisch an die carbonisierten organischen Kohlenstoff-Precursoren oder die organischen Kohlenstoff-Precursoren anbinden können. Die angebundenen Oberflächengruppen können funktionelle Gruppen enthalten und wahlweise monomer oder polymer sein. Sie können nur an einer oder mehreren Molekülketten an der Si-Oberfläche angebunden sein oder mehrere Si-Partikel miteinander verbrücken.

Die Opfermaterialien können anorganischer oder vorzugsweise organischer Natur sein.

Anorganische Opfermaterialien sind Oxide, Carbonate, Carbide, Nitride oder Sulfide der Elemente Magnesium, Calcium, Zinn, Zink, Titan, Nickel. Konkrete Beispiele für anorganische Opfermaterialien sind Zinkoxid, Magnesiumcarbonat und Nickelsulfid. In Stufe c) können Zinkoxid oder Nickelsulfid beispielsweise mittels carbothermischer Reduktion in flüchtige Verbindungen überführt und freigesetzt werden, und Magnesiumcarbonat durch thermische Zersetzung und Freisetzung von CO₂ Poren bilden.

Typische organische Opfermaterialien haben bei einer Temperatur ausgewählt aus dem Bereich von 25 bis 1000°C einen Masseverlust von ≥ 50 Gew.-%, bevorzugt ≥ 80 Gew.-% und besonders bevorzugt ≥ 90 Gew.-%.

Organische Opfermaterialien sind Polyethylen, Polypropylen, Polystyrol, Polybutadien, Poly-tert-Butoxystyrol, Polyvinylchlorid, Polyvinylacetat, Polymethacrylmethacrylat, Polyacrylsäure, Polymethacrylat, Polyvinylstearat, Polyvinyllaurat; Polyvinylalkohol; Alkylenglycole, wie Ethylenglycol, Butylengylcol, Diethylengylcol, Triethylenglycol; Polyalkylenoxide, wie Polyethylenoxide, Polypropylenoxide oder deren Copolymere; Gamma-Butyrolacton, Propylencarbonat; Polyurethane; und Stickstoff-haltige Lösungsmittel, wie Dimethylformamid, Monoethanolamin, N-Methyl-2-pyrrolidinon (NMP).

Bevorzugte Opfermaterialien sind Polymere von ethylenisch ungesättigten Monomeren, Polyalkylenoxide und Alkylenglycole. Besonders bevorzugte Opfermaterialien werden ausgewählt aus der Gruppe umfassend Polyethylen, Polystyrol, Polymethacrylat, Polyethylenoxid, Polypropylenoxid und Polyethylenoxid-Polypropylenoxid-Copolymere.

Das Beschichten der Siliciumpartikel mit Opfermaterial kann beispielsweise nach Physisorptions- oder Chemisorptions-Verfahren erfolgen.

Bei Physisorptions-Verfahren wird das Opfermaterial auf der Oberfläche der Siliciumpartikel abgeschieden. Es kommt zu physikalischen Wechselwirkungen zwischen dem Opfermaterial und den Siliciumpartikeln.

Ein Beispiel für Physisorptions-Verfahren sind Fällungsverfahren. Bei Fällungsverfahren wird beispielsweise Opfermaterial aus Dispersionen enthaltend Opfermaterial, Siliciumpartikel und ein oder mehrere Dispergiermittel ausgefällt. Dispergiermittel können Wasser und/oder organische Lösungsmittel, wie Alkohole oder Kohlenwasserstoffe, sein. Das Ausfällen des Opfermaterials kann in herkömmlicher Weise beispielsweise durch Abkühlen, Aufkonzentrieren oder Zugabe von Fällungsmitteln oder nichtlösenden Solventien erfolgen. Weiterhin können auch elektrostatische Wechselwirkungen zwischen Siliciumpartikeln und Opfermaterial zur Physisorption führen.

Die Mischungen enthaltend ausgefälltes Opfermaterial können direkt getrocknet werden oder zunächst zentrifugiert und/oder filtriert und gegebenenfalls anschließend getrocknet werden. Bei alternativen Physisorptions-Verfahren werden Siliciumpartikel und Lösungen von Opfermaterial gemischt und anschließend getrocknet.

Das Trocknen bei den Physisorptions-Verfahren kann auf herkömmliche Weise erfolgen.

Bevorzugt sind Chemisorptions-Verfahren. Bei der Chemisorption können chemische Bindungen, insbesondere kovalente Bindungen, zwischen dem Opfermaterial und Siliciumpartikeln entstehen. So hergestellte beschichtete Siliciumpartikel sind in den weiteren Verarbeitungsschritten vorteilhaft zu erfindungsgemäßen Si/C-Kompositpartikeln verarbeitbar. Ein Beispiel für Chemisorptions-Verfahren sind Pfropfungsverfahren, wie die "Grafting-to"-Pfropfung oder die "Grafting-from"-Pfropfung. Die Pfropfung kann nach herkömmlichen Polymerisationsverfahren erfolgen, beispielsweise mittels radikalisch initiierter Polymerisation, Polykondensation oder Polyaddition.

Bei der "Grafting-to"-Pfropfung wird allgemein Opfermaterial an Siliciumpartikel angebunden, beispielsweise durch eine Additionsreaktion. Die Additionsreaktionen können radikalisch initiiert sein oder durch Hydrosilylierung erfolgen. Hierzu können beispielsweise Polymere mit Siliciumpartikeln, die Silicium-Wasserstoff-Bindungen auf ihrer Oberfläche tragen, umgesetzt werden. Die Umsetzung kann thermisch, katalytisch, beispielsweise mit Übergangsmetallverbindungen, wie Platin-Verbindungen, mittels UV-Bestrahlung oder durch Zusatz von Radikalbildnern, wie Dibenzoylperoxid oder Azoisobutyronitril, erfolgen.

Bei der "Grafting-from"-Pfropfung werden Monomer-Bausteine für Opfermaterialien in Gegenwart von Siliciumpartikeln polymerisiert. Dabei können Monomere an die Oberfläche der Siliciumpartikel angebunden werden. Die Pfropfung mit ethylenisch ungesättigten Monomeren nach radikalisch initiierter Polymerisation kann mit gängigen Radikalinitiatoren, wie Dibenzoylperoxid oder Azoisobutyronitril, initiiert und in an sich gängiger Weise durchgeführt werden. Für die Polyaddition können beispielsweise mit Epoxid- oder Amin-Gruppen funktionalisierte Siliciumpartikel eingesetzt werden. Geeignete Monomere für die Polyaddition tragen dementsprechend beispielsweise Amin- oder EpoxidGruppen. Schließlich können Alkohol-Gruppen-, insbesondere Phenol-Gruppen-tragende Siliciumpartikeln als Monomer-Bausteine bei der Polykondensation von Phenol- oder Resorcinharzen eingesetzt werden. Entsprechende Alkohol-Gruppen-tragende Siliciumpartikel sind beispielsweise zugänglich durch Hydrosilylierung von Silicium-Wasserstoff-Bindungen tragenden Siliciumpartikeln mit ethylenisch ungesättigten Alkoholen.

Die Beschichtung basierend auf den Opfermaterialien hat eine mittlere Schichtdicke im Bereich von vorzugsweise 5 bis 700 nm, besonders bevorzugt 20 bis 300 nm und am meisten bevorzugt 50 bis 100 nm (Bestimmungsmethode: Elektronen-Mikroskopie (REM)). Die Beschichtung basierend auf den Opfermaterialien weist zumindest an einer Stelle eine Schichtdicke von vorzugsweise 1 bis 300 nm, besonders bevorzugt 20 bis 200 nm und am meisten bevorzugt 50 bis 100 nm auf (Bestimmungsmethode: Raster-Elektronen-Mikroskopie (REM)).

Geeignete Kohlenstoff-Precursoren der Stufe b) sind Resorcin-Formaldehyd-Harz, Lignin und Polyacrylnitril.

In Stufe b) können gegebenenfalls ein oder mehrere Zusatzstoffe eingesetzt werden. Die Zusatzstoffe basieren beispielsweise auf Kohlenstoff unterschiedlicher Modifikation, wie Graphit, (Leit-)Ruß, amorpher Kohlenstoff, pyrolytischer Kohlenstoff, Soft-Carbon, Hard-Carbon, Carbon Nanotubes (CNTs), Fullerene, Graphen oder auf den Elementen Li, Fe, Al, Cu, Ca, K, Na, S, Cl, Zr, Ti, Pt, Ni, Cr, Sn, Mg, Ag, Co, Zn, B, P, Sb, Pb, Ge, Bi, Seltene Erden oder deren Kombinationen. Bevorzugte Zusatzstoffe sind Leitruß, Carbon Nanotubes, Li und Sn. Der Gehalt an Zusatzstoffen ist bevorzugt ≤ 1 Gew.-% und besonders bevorzugt ≤ 100 ppm, bezogen auf das Gesamtgewicht der Si/C-Kompositpartikel.

Die Produkte aus Stufe a), die organischen Kohlenstoff-Precursoren und die gegebenenfalls eingesetzten Zusatzstoffe werden im Folgenden auch gemeinsam als Edukte der Stufe b) bezeichnet.

In Stufe b) werden die Produkte aus Stufe a) mit den weiteren Edukten der Stufe b) beschichtet bzw. in die weiteren Edukte der Stufe b) eingebettet. Die einzelnen Edukte der Stufe b) können alle gleichzeitig oder einzeln nacheinander eingesetzt werden.

Beispielsweise können die Edukte der Stufe b) mittels Mahlen gemischt werden. Beim Mahlen können die Edukte der Stufe b) in trockener Form oder in Form von Dispersionen oder Lösungen vorliegen. Das Mahlen erfolgt vorzugsweise hochenergetisch, beispielsweise mittels (Planeten)Kugelmühlen oder Scheibenschwingmühlen. Alternativ werden zuerst die organischen Kohlenstoff-Precursoren in einem Lösungsmittel gelöst oder dispergiert und anschließend werden die Produkte aus Stufe a) zugegeben. Hierbei können gängige Rührer, Ultraturrax, Dissolver, Intensivmischer, Speedmixer oder auch Ultraschall Einsatz finden.

Lösungsmittel für die Dispersionen oder Lösungen beim Mahlen, Dispergieren oder Mischen sind beispielsweise Wasser oder organische Lösungsmittel oder deren Mischungen. Beispiele für organische Lösungsmittel sind Alkohole, wie Ethanol oder Propanol, Dimethylformamid oder Kohlenwasserstoffe, wie Xylol. Bevorzugt werden Lösungsmittel ausgewählt, in denen die organischen Kohlenstoff-Precursoren gut löslich, die Opfermaterialen aber nicht oder schlecht löslich sind. Von Vorteil ist es, wenn die Edukte der Stufe b) durch die Lösungsmittel gut benetzbar sind.

Die Präkomposite aus Stufe b) können auf unterschiedliche Weise aus so den erhaltenen Dispersionen isoliert werden, beispielsweise durch Fällungsverfahren und/oder durch Trocknen, vorzugsweise analog wie für die Isolierung der Produkte der Stufe a) beschrieben.

In alternativen Verfahren zur Herstellung der Präkomposite können die Produkte aus Stufe a) auch in eine Schmelze von organischen Kohlenstoff-Precursoren eingebracht werden. Anschließendes Abkühlen und Erstarren der Schmelze ergibt Präkomposite.

Bevorzugt sind die Verfahren in Schmelze, besonders bevorzugt sind die Verfahren in Lösungsmittel.

Alternativ können die Präkomposite auch gewonnen werden, indem organische Kohlenstoff-Precursoren mittels Polymerisation in Gegenwart der Produkte aus Stufe a) hergestellt werden. Dazu können gängige Monomer-Bausteine für organische Kohlenstoff-Precursoren Einsatz finden. Die Polymerisation kann auf herkömmliche Weise nach radikalisch initiierten Polymerisationsverfahren oder mittels Polyaddition oder Polykondensation erfolgen. Bei der radikalisch initiierten Polymerisation werden ein oder mehrere ethylenisch ungesättigte Monomere, wie Acrylnitril, polymerisiert. Das Initiieren der Polymerisation kann hierbei thermisch und/oder durch Zusatz von Radikalstartern, wie Dibenzoylperoxid oder Azoisobutyronitril, erfolgen. Ein Beispiel für die Polykondensation ist die Kondensation von Resorcin und Formaldehyd zu Resorcin-Formaldehydharz. Ein Beispiel für die Polyaddition ist die Addition von Bisphenol-A-diglycidylether mit organischen Aminen zu Epoxidharzen.

Auf die so erhaltenen Präkomposite können ein oder mehrere zusätzliche Beschichtungen basierend auf organischen Kohlenstoff-Precursoren und gegebenenfalls Zusatzstoffen gemäß Stufe b) aufgebracht werden.

Die Präkomposite der Stufe b) können in feuchter oder trockener Form in Stufe c) eingesetzt werden. Die Präkomposite der Stufe b) können vor der weiteren Verarbeitung gemahlen oder durch Klassierungstechniken, wie Sieben oder Sichten, von Über- oder Unterkorn befreit werden.

In Stufe c) werden die Präkomposite der Stufe b) in poröse Komposite überführt.

Die thermische Behandlung des Präkomposits der Stufe b) erfolgt bei Temperaturen von vorzugsweise 400 bis 1400°C, besonders bevorzugt 500 bis 1200°C und am meisten bevorzugt 700 bis 1100°C.

Die thermische Behandlung in Stufe c) kann beispielsweise in einem Rohrofen, Drehrohrofen oder einem Wirbelschichtreaktor stattfinden. Durch Wahl des Reaktortyps kann die Carbonisierung statisch oder unter ständiger Durchmischung des Reaktionsmediums durchgeführt werden.

Die thermische Behandlung wird vorzugsweise in einer Inertgas-Atmosphäre, wie Stickstoff- oder vorzugsweise Argon-Atmosphäre, durchgeführt. Die Inertgas-Atmosphäre kann gegebenenfalls zusätzlich Anteile eines reduzierenden Gases, wie Wasserstoff, enthalten. Die thermische Behandlung erfolgt vorzugsweise anaerob. Die Inertgas-Atmosphäre kann sich statisch über dem Reaktionsmedium befinden oder in Form eines Gasflusses über die Reaktionsmischung strömen. Die Flussraten betragen hierbei vorzugsweise bis zu 1 Liter pro Minute, besonders bevorzugt 100 bis 600 mL/min und am meisten bevorzugt 250 mL/min, insbesondere im Falle der Carbonisierung von 2 bis 150 g Präkompositen aus Stufe b).

Die Heizraten beim Aufheizen der Reaktionsmischung betragen vorzugsweise 1 bis 20°C pro Minute, mehr bevorzugt 1 bis 15°C/min, besonders bevorzugt 1 bis 10°C/min und am meisten bevorzugt 3 bis 5°C/min. Weiterhin ist auch ein stufenweiser Prozess mit verschiedenen Zwischentemperaturen und -heizraten möglich. Nach Erreichen der Zieltemperatur wird die Reaktionsmischung üblicherweise eine gewisse Zeit bei der Temperatur getempert oder anschließend sogleich abgekühlt. Vorteilhaft sind Haltedauern von beispielsweise 30 min bis 24 h, bevorzugt 1 bis 10 h und besonders bevorzugt 2 bis 4 h. Das Abkühlen kann aktiv oder passiv, gleichmäßig oder stufenweise durchgeführt werden.

Die so erhaltenen porösen Komposite der Stufe c) können unmittelbar in Stufe d) eingesetzt werden. Alternativ kann vorher mechanisch, z.B. durch Mahlung oder Siebung, nachbehandelt werden sowie durch Klassierungstechniken (Sieben, Sichten) von Über- oder Unterkorn befreit werden.

Durch die thermische Behandlung des Präkomposits in Stufe c) erfolgt eine Carbonisierung der organischen Kohlenstoff-Precursoren. Die organischen Kohlenstoff-Precursoren werden dabei vorzugsweise in anorganischen Kohlenstoff überführt.

Die Kohlenstoffausbeuten beim Carbonisieren der organischen Kohlenstoff-Precursoren betragen vorzugsweise ≥ 15%, mehr bevorzugt ≥ 20%, noch mehr bevorzugt ≥ 25%, besonders bevorzugt ≥ 50% und am meisten bevorzugt ≥ 70%, bezogen auf das Gesamtgewicht der organischen Kohlenstoff-Precursoren.

Die porösen Komposite der Stufe c) haben volumengewichtete Partikelgrößenverteilungen mit Durchmesser-Perzentilen d₅₀ von vorzugsweise ≥ 1 pm, besonders bevorzugt ≥ 5 µm und am meisten bevorzugt ≥ 10 µm. Die porösen Komposite haben d₅₀-Werte von vorzugsweise ≤ 90 µm, mehr bevorzugt ≤ 50 µm, besonders bevorzugt ≤ 36 µm und am meisten bevorzugt ≤ 20 µm. Die volumengewichtete Partikelgrößenverteilung ist bestimmbar nach ISO 13320 mittels statischer Laserstreuung unter Anwendung des Mie-Modells mit dem Messgerät Horiba LA 950 mit Ethanol als Dispergiermedium für die porösen Kompositpartikel.

In Stufe c) wird Opfermaterial des Präkomposits freigesetzt. Dadurch bilden sich Poren im Komposit. Die einzelnen Poren liegen vorzugsweise isoliert vor. Die Poren sind vorzugsweise nicht über Kanäle miteinander verbunden. Die Form der Poren kann beispielsweise ellipsoid, länglich, eckig, splitterförmig oder vorzugsweise sphärisch sein.

Die Porenwände haben vorzugsweise eine Dicke von 4 bis 330 nm, besonders bevorzugt von 24 bis 240 nm und am meisten bevorzugt von 50 bis 146 nm (Bestimmungsmethode: Raster-Elektronen-Mikroskopie (REM)). Die Dicke der Porenwände bezeichnet den kürzesten Abstand zwischen zwei Poren.

In Folge des erfindungsgemäßen Verfahrens befinden sich Siliciumpartikel in Poren. Die Poren, die Siliciumpartikel enthalten, enthalten vorzugsweise ≤ 10, besonders bevorzugt ≤ 5, noch mehr bevorzugt ≤ 3 und am meisten bevorzugt einen Siliciumpartikel. Der Anteil der Siliciumpartikel, die sich in Poren befinden, beträgt ≥ 80% und am meisten bevorzugt ≥ 90%, bezogen auf die Gesamtzahl der Siliciumpartikel in den porösen Kompositen der Stufe c) (Bestimmungsmethode: Raster-Elektronen-Mikroskopie (REM)).

Das Volumen einer Pore entspricht vorzugsweise mindestens dem Dreifachen und besonders bevorzugt mindestens dem 3,2-fachen und am meisten bevorzugt mindestens dem 3,3-fachen des Volumens des darin befindlichen Siliciumpartikels. Das Volumen einer Pore entspricht vorzugsweise höchstens dem 4-fachen und besonders bevorzugt höchstens dem 3,7-fachen und am meisten bevorzugt höchstens dem 3,4-fachen des Volumens des darin befindlichen Siliciumpartikels (Bestimmungsmethode: 1 minus [Quotient aus der Rohdichte (bestimmt mittels Xylol-Pyknometrie gemäß DIN 51901) und der Skelettdichte (bestimmt mittels He-Pyknometrie gemäß DIN 66137-2)]).

Die Poren, die Siliciumpartikel enthalten, haben Durchmesser von vorzugsweise ≥ 60 nm, mehr bevorzugt ≥ 80 nm, besonders bevorzugt ≥ 160 nm und am meisten bevorzugt ≥ 290 nm. Die Poren, die Siliciumpartikel enthalten, haben Durchmesser von vorzugsweise ≤ 1400 nm, mehr bevorzugt ≤ 700 nm, besonders bevorzugt ≤ 500 nm und am meisten bevorzugt ≤ 350 nm (Bestimmungsmethode: Raster-Elektronen-Mikroskopie (REM)). Die Maßgaben betreffend Poren-Durchmesser werden vorzugsweise von dem größten Durchmesser von zwei, besonders bevorzugt drei zueinander orthogonalen Durchmessern erfüllt. Das Volumen eines Siliciumpartikels, der sich in einer Pore befindet, wird bei der Bestimmung eines Poren-Durchmessers dem Volumen der Pore zugeschlagen.

Das Verhältnis der Durchmesser der Poren, die Siliciumpartikel enthalten, und der Durchmesser der Siliciumpartikel ist vorzugsweise ≥ 1,1, besonders bevorzugt ≥ 1,6 und am meisten bevorzugt ≥ 1,8. Das vorgenannte Verhältnis der Durchmesser ist vorzugsweise ≤ 3, besonders bevorzugt ≤ 2,5 und am meisten bevorzugt ≤ 2 (Bestimmungsmethode: Raster-Elektronen-Mikroskopie (REM)).

Die porösen Komposite der Stufe c) basieren vorzugsweise zu 40 bis 90 Gew.-% und besonders bevorzugt 60 bis 80 Gew.-% auf Kohlenstoff. Die porösen Komposite der Stufe c) enthalten vorzugsweise 10 bis 60 Gew.-% und besonders bevorzugt 15 bis 40 Gew.-% Siliciumpartikel. Die Angaben in Gew.-% beziehen sich auf das Gesamtgewicht der porösen Komposite der Stufe c).

In Stufe d) werden auf die porösen Komposite der Stufe c) eine oder mehrere Kohlenstoffbeschichtungen aufgebracht.

In einer Variante von Stufe d) werden die porösen Komposite der Stufe c) zunächst mit einer oder mehreren Kohlenstoff-Vorstufen a) beschichtet und anschließend werden die so aufgebrachten Kohlenstoff-Vorstufen α) durch thermische Behandlung carbonisiert.

Die Kohlenstoff-Vorstufen a) ergeben nach Carbonisieren mittels thermischer Behandlung im Allgemeinen hohe Ausbeuten an Kohlenstoff. Die Kohlenstoffausbeuten betragen vorzugsweise ≥ 40%, besonders bevorzugt ≥ 50% und am meisten bevorzugt ≥ 70%.

Beispiele für Kohlenstoff-Vorstufen a) der Stufe d) sind Teere oder Peche, insbesondere hochschmelzende Peche, HardCarbon (nicht-graphitisierbar bei Temperaturen von 2500 bis 3000°C) oder SoftCarbon (graphitisierbar bei Temperaturen von 2500 bis 3000°C). Besonders bevorzugt sind Mesogenes Pech, Mesophasen-Pech, Petrolpech und Steinkohlenteerpech.

Das Beschichten der porösen Komposite der Stufe c) mit Kohlenstoff-Vorstufen a) kann beispielsweise analog erfolgen, wie oben in Stufe b) für das Beschichten der Produkte aus Stufe a) mit Kohlenstoff-Precursoren beschrieben.

Die so erhaltenen, beschichteten porösen Komposite der Stufe c) können dann durch thermische Behandlung carbonisiert werden. Die thermische Behandlung kann hierbei analog durchgeführt werden wie in Stufe c) für die Carbonisierung der Präkomposite der Stufe b) beschrieben.

In einem alternativen Verfahren für Stufe d) können die porösen Komposite der Stufe c) mittels chemischer Gasphasenabscheidung (chemical vapor deposition, CVD) mit Kohlenstoff beschichtet werden.

Für das CVD-Verfahren geeignete Kohlenstoff-Vorstufen β) sind beispielsweise Kohlenwasserstoffe, wie aliphatische Kohlenwasserstoffe mit 1 bis 10 Kohlenstoffatomen, insbesondere 1 bis 4 Kohlenstoffatomen. Beispiele hierfür sind Methan, Ethan, Propan, Propylen, Butan, Buten, Pentan, Isobutan, Hexan; ungesättigte Kohlenwasserstoffe mit 1 bis 4 Kohlenstoffatomen, wie Ethylen, Acetylen oder Propylen; aromatische Kohlenwasserstoffe, wie Benzol, Toluol, Styrol, Ethylbenzol, Diphenylmethan oder Naphthalin; weitere aromatische Kohlenwasserstoffe, wie Phenol, Cresol, Nitrobenzol, Chlorbenzol, Pyridin, Anthracen, Phenanthren.

Bevorzugte Kohlenstoff-Vorstufen β) für das CVD-Verfahren sind Methan, Ethan und insbesondere Ethylen, Acetylen, Benzol oder Toluol.

Beim CVD-Verfahren werden die porösen Komposite der Stufe c) vorzugsweise in einem Gasstrom enthaltend eine oder mehrere, im allgemeinen gasförmige, Kohlenstoff-Vorstufen β) erhitzt. Wie üblich zersetzen sich die Kohlenstoff-Vorstufen β) dabei an der heißen Oberfläche der Siliciumpartikel unter Abscheidung von Kohlenstoff. Generell können die allgemein bekannten CVD-Verfahren Anwendung finden.

An den Si/C-Kompositpartikeln der Stufe d) können weitere Oberflächenmodifikationen vorgenommen werden. Es können auch ein oder mehrere weitere Beschichtungen gemäß Stufe d) aufgebracht werden.

Die Si/C-Kompositpartikel tragen vorzugsweise eine Kohlenstoffschicht als oberste Beschichtung. Die Si/C-Kompositpartikel tragen vorzugsweise die in Stufe d) hergestellte Beschichtung als oberste Beschichtung. Die Kohlenstoffbeschichtung der Stufe d) beziehungsweise die oberste Beschichtung der Si/C-Kompositpartikel ist vorzugsweise unporös. Die Unporösität kann über die Porendurchmesser charakterisiert werden.

Die Poren der in Stufe d) auf die porösen Komposite der Stufe c) aufgebrachten Kohlenstoff-Beschichtung sind vorzugsweise ≤ 10 nm, besonders bevorzugt ≤ 5 nm und am meisten bevorzugt ≤ 2 nm. Nicht erwünscht sind Mesoporen mit Porendurchmessern von beispielsweise > 2 nm und insbesondere > 10 nm (Bestimmungsmethode: Porengrößenverteilung nach BJH (Gasadsorption) gemäß DIN 66134).

Die in Stufe d) aufgebrachte Kohlenstoff-Beschichtung der Si/C-Kompositpartikel hat vorzugsweise eine Porosität von ≤ 2% und besonders bevorzugt ≤ 1% (Bestimmungsmethode der Gesamtporosität: 1 minus [Quotient aus Rohdichte (bestimmt mittels Xylol-Pyknometrie gemäß DIN 51901) und Skelettdichte (bestimmt mittels He-Pyknometrie gemäß DIN 66137-2)]).

Die in Stufe d) aufgebrachte Kohlenstoff-Beschichtung beziehungsweise die oberste Beschichtung der Si/C-Kompositpartikel ist vorzugsweise flüssigkeitsdicht, vorzugsweise elektrisch leitfähig und/oder vorzugsweise leitfähig für Lithiumionen. Besonders bevorzugt sind die Si/C-Kompositpartikel undurchlässig für wässrige oder organische Elektrolyte, Säuren oder Laugen. Die Flüssigkeitsdichtigkeit der Si/C-Kompositpartikel ist vorzugsweise ≥ 95%, besonders bevorzugt ≥ 96% und am meisten bevorzugt ≥ 97%. Die Flüssigkeitsdichtigkeit kann beispielsweise bestimmt werden entsprechend der weiter unten für die Beispiele angegebenen Bestimmungsmethode.

Die Si/C-Kompositpartikel können beispielsweise als isolierte Partikel oder als lockere Agglomerate vorliegen. Die Si/C-Kompositpartikel können in Form von Splittern oder Flakes oder vorzugsweise in sphärischer Form vorkommen.

Die volumengewichtete Partikelgrößenverteilung mit Durchmesser-Perzentilen d₅₀ der Si/C-Kompositpartikel beträgt vorzugsweise ≤ 1 mm, bevorzugt ≤ 90 µm besonders bevorzugt ≤ 50 µm und ganz besonders bevorzugt ≤ 20 µm, aber vorzugsweise ≥ 1 µm, besonders bevorzugt ≥ 5 µm und am meisten bevorzugt ≥ 10 µm. Die Partikelgrößenverteilung ist bevorzugt monomodal, kann aber auch bimodal oder polymodal sein und ist vorzugsweise schmal. Die volumengewichtete Partikelgrößenverteilung der Si/C-Kompositpartikel ist charakterisiert durch einen Wert für (d₉₀-d₁₀)/d₅₀ von vorzugsweise ≤ 1, besonders bevorzugt ≤ 0,95.

Die Si/C-Kompositpartikel haben BET-Oberflächen von vorzugsweise ≤ 50 m²/g, besonders bevorzugt ≤ 20 m²/g und am meisten bevorzugt ≤ 10 m²/g (Bestimmung gemäß DIN 66131 (mit Stickstoff)).

Die Dichte der Si/C-Kompositpartikel ist vorzugsweise ≥ 0,85 g/cm³ und besonders bevorzugt ≥ 1,00 g/cm³ (Bestimmungsmethode: Xylol-Pyknometrie gemäß DIN 51901).

Bei dem in den Si/C-Kompositpartikeln enthaltenen Kohlenstoff kann es sich ausschließlich um einen durch Carbonisierung erhaltenen Kohlenstoff handeln. Alternativ können auch weitere Komponenten als Kohlenstoffquelle enthalten sein, wie beispielsweise Graphit, Leitruß, Carbon Nanotubes (CNTs) oder andere Kohlenstoffmodifikationen. Bevorzugt ist ein hoher Anteil des Kohlenstoffs der Si/C-Kompositpartikel durch Carbonisierung in den Stufen c) und d) hergestellt, bevorzugt ≥ 40 Gew.-%, besonders bevorzugt ≥ 70 Gew.-% und am meisten bevorzugt ≥ 90 Gew.-%, bezogen auf die Gesamtmasse des Kohlenstoffs der Si/C-Kompositpartikel. Alternativ können 40 bis 90 Gew.-% oder 60 bis 80 Gew.-% des Kohlenstoffs der Si/C-Kompositpartikel durch Carbonisierung in den Stufen c) und d) hergestellt sein, bezogen auf die Gesamtmasse des Kohlenstoffs der Si/C-Kompositpartikel.

Der Anteil der in Stufe d) hergestellten Beschichtung beträgt vorzugsweise 1 bis 25 Gew.-%, besonders bevorzugt 5 bis 20 Gew.-% und am meisten bevorzugt 7 bis 15 Gew.-%, bezogen auf das Gesamtgewicht der Si/C-Kompositpartikel.

Die Si/C-Kompositpartikel basieren zu vorzugsweise 80 bis 95 Gew.-% und besonders bevorzugt 85 bis 93 Gew.-% auf den porösen Kompositen der Stufe c), bezogen auf das Gesamtgewicht der Si/C-Kompositpartikel.

Die Si/C-Kompositpartikel enthalten vorzugsweise 5 bis 50 Gew.-%, besonders bevorzugt 10 bis 40 Gew.-% und am meisten bevorzugt 20 bis 40 Gew.-% Siliciumpartikel. Kohlenstoff ist in den Si/C-Kompositpartikeln zu vorzugsweise 50 bis 95 Gew.-%, besonders bevorzugt 60 bis 85 Gew.-% und am meisten bevorzugt 60 bis 80 Gew.-% enthalten. Gegebenenfalls können auch Sauerstoff und vorzugsweise Stickstoff in den Si/C-Kompositpartikeln enthalten sein; diese liegen im Allgemein chemisch gebunden in Form von Heterocyclen in der Kohlenstoffstruktur vor, wie Pyridin- und Pyrrol-Einheiten (N), Furan (O) oder Oxazole (N, O). Der Sauerstoff-Gehalt der Si/C-Kompositpartikel ist vorzugsweise ≤ 20 Gew-%, besonders bevorzugt ≤ 10 Gew-% und am meisten bevorzugt ≤ 5 Gew-%. Der Stickstoff-Gehalt der Si/C-Kompositpartikel ist vorzugsweise im Bereich von 0,5 bis 10 Gew.-% und besonders bevorzugt 2 bis 5 Gew.-%. Die Angaben in Gew.-% beziehen sich jeweils auf das Gesamtgewicht eines Si/C-Kompositpartikels und addieren sich insgesamt zu 100 Gew.-% auf.

Die Si/C-Kompositpartikel können gegebenenfalls zusätzliche Komponenten enthalten, beispielsweise basierend auf inaktiven Materialien, wie Metallen (z. B. Kupfer), Oxiden, Carbiden oder Nitriden. Damit kann die elektrochemische Stabilität positiv beeinflusst werden.

Die Si/C-Kompositpartikel weisen allgemein eine überraschend hohe Stabilität bei Druckbelastung und/oder Scherbelastung auf. Die Druckstabilität und die Scherstabilität der Si/C-Kompositpartikel manifestieren sich beispielsweise dadurch, dass die Si/C-Kompositpartikel bei Druck- beziehungsweise ScherBelastung keine oder nur eine geringfügige Änderung ihrer Durchmesser-Perzentilen d₅₀ (volumengewichtete Partikelgrößenverteilung) erfahren.

Die Änderung der Durchmesser-Perzentilen d₅₀ (volumengewichtete Partikelgrößenverteilung) der Si/C-Kompositpartikel durch eine Druckbelastung von 17 MPa beträgt vorzugsweise ≤ 15%, bezogen auf die Durchmesser-Perzentilen d₅₀ (volumengewichtete Partikelgrößenverteilung) der Si/C-Kompositpartikel vor der Druckbelastung. Die Messung der Druckstabilität erfolgt mittels einer hydraulischen Tablettenpresse (Fa. Specac), deren Pressform (Durchmesser 12 mm) mit Si/C-Kompositpartikel befüllt (Füllhöhe: 0,5 cm) und anschließend mit einem Gewicht von 0,2 t (17 MPa) belastet wird. Der angelegte Druck orientiert sich am Druck zur Verdichtung von Graphitelektroden auf 1,6 g/cm³.

Die Änderung der Durchmesser-Perzentilen d₅₀ (volumengewichtete Partikelgrößenverteilung) der Si/C-Kompositpartikel durch Scherbelastung (Dissolver; 16 m/s; 30 min) ist vorzugsweise ≤ 15%, bezogen auf die Durchmesser-Perzentilen d₅₀ (volumengewichtete Partikelgrößenverteilung) der Si/C-Kompositpartikel vor der Scherbelastung. Zur Messung der Scherstabilität wird eine Dispersion der Si/C-Kompositpartikel in einer Lösung von Natrium-Carboxymethylcellulose (Na-CMC, Daicel 1380) (1,4% Na-CMC in Wasser; Gewichtsverhältnis: Si/C-Kompositpartikel zu Na-CMC = 90:10) mit einem Dissolver (Fa. Getzmann, Dispermat) gerührt (Umlaufgeschwindigkeit 16 m/s).

Ein weiterer Gegenstand der vorliegenden Erfindung ist die Verwendung der erfindungsgemäßen Si/C-Kompositpartikel in Elektrodenmaterialien für Lithiumionen-Batterien, insbesondere zur Herstellung der negativen Elektroden von Lithiumionen-Batterien.

Die Si/C-Kompositpartikel können als Silicium-Komponente für Elektrodenmaterialien von Lithiumionen-Batterien eingesetzt werden. Die Herstellung entsprechender Lithiumionen-Batterien kann beispielsweise erfolgen, wie in der WO 2015/117838 beschrieben.

Vorteilhafter Weise kann die Einbettung des Siliciums in Poren und in eine Kohlenstoffmatrix in einer einzigen Stufe erfolgen (erfindungsgemäße Stufe c)), was ökonomisch mit einem großen Vorteil verbunden ist. Überraschenderweise wurden gezielt um die Siliciumpartikel Poren in der gewünschten Größe erhalten. Separate Ätzschritte, wie im Stand der Technik zur Erzeugung von Poren vielfach beschrieben, können somit entfallen. Zudem kann bei dem erfindungsgemäßen Verfahrensschritt c) eine charakteristische, vorteilhafte Anbindung von Siliciumpartikeln an die Kohlenstoff-Matrix der Si/C-Kompositpartikel stattfinden, wodurch eine Verbesserung der elektrischen Kontaktierung bewirkt werden kann.

Die erfindungsgemäß hergestellten Si/C-Kompositpartikel haben ein vorteilhaftes, wohldefiniertes Strukturdesign, das bei entsprechendem Einsatz der Si/C-Kompositpartikel in Lithium-Ionen-Batterien vorteilhafte anwendungstechnische Eigenschaften bewirkt. Die Siliciumpartikel sind in Poren der Kohlenstoffmatrix eingebettet, wobei die Größe der Poren beeinflusst werden kann. Die Poren vermögen die Volumenausdehnung des Siliciums beim Laden von Lithiumionen-Batterie abzupuffern und damit das elektrochemische Mahlen zu reduzieren. Darüber hinaus können die Siliciumpartikel auf Grund der erfindungsgemäßen Ausgestaltung der Si/C-Kompositpartikel vor flüssigen Medien geschützt werden und die SEI-Bildung, beispielsweise durch Elektrolyte, Säuren oder Laugen, in entsprechenden Lithiumionen-Batterien vermindert werden. Damit kann während des Betriebs der Lithiumionen-Batterien das Abplatzen der SEI-Schicht unterbunden oder verringert werden, was die SEI-Problematik weiter reduziert.

Die erfindungsgemäßen Si/C-Kompositpartikel sind auch überraschend stabil und mechanisch belastbar und verfügen insbesondere über eine hohe Druckstabilität und eine hohe Scherstabilität. Die Partikel neigen bei mechanischer Beanspruchung weniger zum Zerbröseln als herkömmliche poröse Kompositpartikel.

Die Partikelgröße der Si/C-Kompositpartikel kann flexibel eingestellt werden. Die Kompositpartikel sind im Allgemeinen nicht aggregiert und durch eine schmale Partikelgrößenverteilung ausgezeichnet. Dies ermöglicht eine verbesserte Verarbeitbarkeit der Materialien zu Elektrodentinten und -beschichtungen und eine homogene Verteilung der Partikel in den Elektroden. Zudem ist dies ist zur Herstellung von robusten Lithiumionen-Batterien hilfreich.

Erfindungsgemäße Si/C-Kompositpartikel führen vorteilhafterweise zu Lithiumionen-Batterien mit hohen gravimetrischen Kapazitäten und zudem hohen volumetrischen Kapazitäten und somit insgesamt zu Lithiumionen-Batterien mit hohen Energiedichten.

Für all diese Effekte tragen die erfindungsgemäßen Verfahrensschritte und die charakteristischen Merkmale der Si/C-Kompositpartikel in synergistischer Weise bei.

Die folgenden Beispiele dienen zur weiteren Erläuterung der Erfindung, sind aber nicht limitierend für deren Umfang.

Sofern nicht anders angegeben, wurden die nachstehenden Beispiele in einer Atmosphäre aus trockenem Argon 5.0, bei einem Druck von 1013 mbar und einer Temperatur von 23 °C durchgeführt. Die Lösungsmittel wurden nach Standardverfahren getrocknet und unter einer trockenen Argon-Atmosphäre aufbewahrt.

Folgende analytische Methoden und Geräte wurden zur Charakterisierung eingesetzt:

### Carbonisierung:

Alle in den Beispielen durchgeführten Carbonisierungen wurden mit einem 1200 °C Drei-Zonen Rohrofen (TFZ 12/65/550/E301) der Fa. Carbolite GmbH unter Verwendung einer Kaskadenregelung inklusive eines Probenthermoelements Typ N durchgeführt. Die angegebenen Temperaturen beziehen sich auf die Innentemperatur des Rohrofens am Ort des Thermoelements. Das jeweils zu carbonisierende Ausgangsmaterial wurde in ein oder mehrere Verbrennungsschiffchen aus Quarzglas (QCS GmbH) eingewogen und in ein Arbeitsrohr aus Quarzglas eingebracht. Die für die Carbonisierungen verwendeten Einstellungen und Prozessparameter sind in den jeweiligen Beispielen angegeben.

### Klassierung/Siebung:

Die nach der Carbonsierung erhaltenen Si/C-Pulver wurden durch Nasssiebung mit einer Siebmaschine AS 200 basic (Retsch GmbH) mit Wasser an Edelstahlsieben von Überkorn >20 µm befreit. Das Si/C-Pulver wurde in Ethanol mittels Ultraschall (Hielscher UIS250V; Amplitude 80%, Cycle: 0,75; Dauer: 30 min) dispergiert (20% Feststoffgehalt) und auf den Siebturm mit einem Sieb (20 pm) aufgebracht. Die Siebung wurde mit einer unendlichen Zeitvorwahl und einer Amplitude von 50-70% bei durchlaufendem Wasserstrom durchgeführt. Die unten austretende, Si/C-Pulver-haltige Suspension wurde über 200 nm-Nylonmembran filtriert, und der Filterrückstand im Vakuumtrockenschrank bei 100 °C und 50-80 mbar bis zur Massenkonstanz getrocknet.

### Rasterelektronemikroskopie (REM/EDX):

Die mikroskopischen Untersuchungen wurden mit einem Rasterelektronemikroskop Zeiss Ultra 55 und einem energiedispersvem Röntgenspektrometer INCA x-sight durchgeführt. Die Proben wurden vor der Untersuchung zur Verhinderung von Aufladungsphänomenen mit einem Baltec SCD500 Sputter-/Carbon-Coating mit Kohlenstoff bedampft. Die in den Abbildungen gezeigten Querschnitte der Si/C-Kompositpartikel wurden mit einem Ionencutter Leica TIC 3X bei 6 kV erzeugt.

### Anorganische Analytik / Elementaranalyse:

Die in den Beispielen angegebenen C-Gehalte wurden mit einem Leco CS 230 Analysator ermittelt, zur Bestimmung von 0- und ggf. N- bzw. H-Gehalten wurde ein Leco TCH-600 Analysator eingesetzt. Die qualitative und quantitative Bestimmung von anderen angebenen Elementen in den erhaltenene Kern-Schale-Kompositpartikeln wurden mittels ICP (inductively coupled plasma)-Emissionspektrometrie (Optima 7300 DV, Fa. Perkin Elmer) bestimmt. Die Proben wurden dazu in einer Mikrowelle (Microwave 3000, Fa. Anton Paar) sauer aufgeschlossen (HF/HNO3). Die ICP-OES-Bestimmung orientiert sich an der ISO 11885 "Wasserbeschaffenheit - Bestimmung von ausgewählten Elementen durch induktiv gekoppelte Plasma-Atom-Emissionsspektrometrie (ICP-OES) (ISO 11885:2007); Deutsche Fassung EN ISO 11885:2009", die zur Untersuchung saurer, wässriger Lösungen eingesetzt wird (z.B. angesäuerte Trinkwasser-, Abwasser- und andere Wasserproben, Königswasserextrakte von Böden und Sedimenten).

### Partikelgrößenbestimmung:

Die Bestimmung der Partikelgrößenverteilung erfolgte im Rahmen dieser Erfindung nach ISO 13320 mittels statischer Laserstreuung mit einem Horiba LA 950. Dabei muss bei der Vorbereitung der Proben besondere Sorgfalt auf die Dispergierung der Partikel in der Messlösung aufgewendet werden, um statt Einzelpartikel nicht die Größe von Agglomeraten zu messen. Für die hier untersuchten Si/C-Kompositpartikel wurden die Partikel in Ethanol dispergiert. Dazu wurde die Dispersion vor der Messung bei Bedarf 4 min in einem Hielscher Ultraschall-Laborgerät Modell UIS250v mit Sonotrode LS24d5 mit 250 W Ultraschall behandelt.

### Thermogravimetrie (TGA):

Die Bestimmung von Polymer-Gehalten nach der Beschichtung von Silicium-Nanopartikeln wurde mittels Thermogravimetrie mit einer Mettler Thermowaage TGA 851 ermittelt. Die Messung wurde unter Sauerstoff als Messgas im Temperaturbereich von 25-1000 °C und einer Heizrate von 10 °C/min durchgeführt. Aus dem Masseverlust im Temperaturbereich von 25-600 °C lässt dich der Anteil an organischen Materialien (Polymerbeschichtung) ermitteln.

Mit der gleichen Methode wurde das Verhältnis verschiedener Kohlenstoff-Modifikationen in einem Komposit (Leitruß (LR) neben amorphem Kohlenstoff (C)) ermittelt. Bei Anwesenheit von Leitruß und C findet der durch Verbrennung des Gesamtkohlenstoffs verursachte Massenverlust im Temperaturbereich von 400-650 °C in zwei Stufen statt, aus deren Verhältnis das in den betreffenden Beispielen angegebene C:LR-Verhältnis ermittelt wurde.

### Oberflächenmessung nach BET:

Die spezifische Oberfläche der Materialien wurde über Gasadsorption mit Stickstoff mit einem Gerät Sorptomatic 199090 (Porotec) oder Gerät SA-9603MP (Horiba) nach der BET-Methode gemessen.

### Si-Zugänglichkeit gegenüber flüssigen Medien (Flüssigkeitsdichtigkeit) :

Die Bestimmung der Zugänglichkeit von Silicium in den Si/C-Kompositpartikeln gegenüber flüssigen Medien wurde mit folgender Testmethode an Materialien mit bekanntem Silicium-Gehalt (aus Elementaranalyse) durchgeführt:
0,5-0,6 g Si/C-Kompositpartikel wurden mit 20 ml einer Mischung aus NaOH (4M; H₂O) und Ethanol (1:1 vol.) zunächst mittels Ultraschall dispergiert und anschließend 120 min bei 40 °C gerührt. Die Komposit-Partikel wurden über 200 nm Nylonmembran filtriert, mit Wasser mit zum Neutral-pH gewaschen und anschließend im Trockenschrank bei 100 °C/50-80 mbar getrocknet. Der Silicium-Gehalt nach der NaOH-Behandlung wurde bestimmt und mit dem Si-Gehalt vor dem Test verglichen. Bei einer relativen Änderung des Si-Gehalts von ≤5% wird die Komposit-Struktur als dicht angesehen (entspricht einer Dichtigkeit von ≥95%).

### Theoretische Kapazität:

Die in den Beispielen angegebene theoretische Kapazität der erhaltenen Si/C-Kompositpartikel wurde nicht experimentell ermittelt, sondern aus der elementaren Zusammensetzung der Materialien berechnet. Dabei wurden für die Berechnung folgende Kapazitäten der reinen Komponenten zugrunde gelegt: Si 4199 mAh/g; (amorpher) Kohlenstoff 100 mAh/g; N (als Teil der amorphen C-Matrix) 100 mAh/g. Weiterhin wurde bei der Berechnung angenommen, dass in den Kompositen enthaltene O-Gehalte in Form von SiO₂ vorliegen und damit den Beitrag des aktiven Siliciums unter Berücksichtigung des SiO₂ -Gehalts herabsetzen.

Folgende Materialien wurden aus kommerziellen Quellen bezogen bzw. selber hergestellt und ohne weitere Reinigung direkt eingesetzt:
eine Suspension aus Silicium-Nanopulver (splitterförmige, nicht-aggregierte Si-Partikel, selbst hergestellt durch Nassmahlung in einer Rührwerkskugelmühle in Ethanol (Feststoffgehalt 22 Gew-%, d₅₀ = 180 nm) oder 2-Propanol (Feststoff-Gehalt 20 Gew-%; d₅₀ = 200 nm)), Polyacrylnitril (Mw = 150.000; Sigma-Aldrich), Dimethylformamid (DMF; extra pure; Sigma-Aldrich), Polyethylenoxid-Polypropylenoxid-Copolymer (Pluronic P123®; Sigma-Aldrich), Acrylsäure (99%, Sigma-Aldrich), Azobis(iso-butyronitril) (AIBN; Sigma-Aldrich), Toluol (Brenntag GmbH), Pech (hochschmelzend; Erweichungspunkt 235 °C).

### Beispiel 1:

### Beschichtung von Silicium-Nanopulver mit einem porenbildenden Polymer (Polyacrylsäure):

Eine Silicium-Nanopulver-Suspension (25 g, 20 Gew-%, d₅₀ = 200 nm in 2-Propanol; entspricht 5 g Nano-Silicium) wurde mit 50 ml Toluol versetzt und 2-Propanol durch Destillation entfernt. Die erhaltene Suspension wurde mit 80 ml Toluol verdünnt und mit Ultraschall (Hielscher UIS250V; Amplitude 50%, Cycle: 0,9; Dauer: 5 min) redispergiert. Es wurden 115 mg Azobis(isobutyronitril) (AIBN) und 5 g Acrylsäure hinzugegeben, und die erhaltene Reaktionsmischung wurde anschließend 3 h bei 100 °C gerührt und innerhalb von 14 h auf Raumtemperatur abgekühlt. Die Partikel wurden durch Zentrifugation (5 min, 6000 rpm) abgetrennt, mit Toluol gewaschen und im Vakuum getrocknet (80 °C, 10-2 mbar, 3 h).

Elementare Zusammensetzung: C 27,3 Gew-%; O 26,3 Gew-%; N 0,5 Gew-%; H 3,8 Gew-%;
Zusammensetzung des unbeschichteten Ausgangsmaterials: C 2,1 Gew-%; O 4,4 Gew-%; N 0,2 Gew-%; H 0,5 Gew-%;
Polymergehalt (TGA): 49 Gew-%.

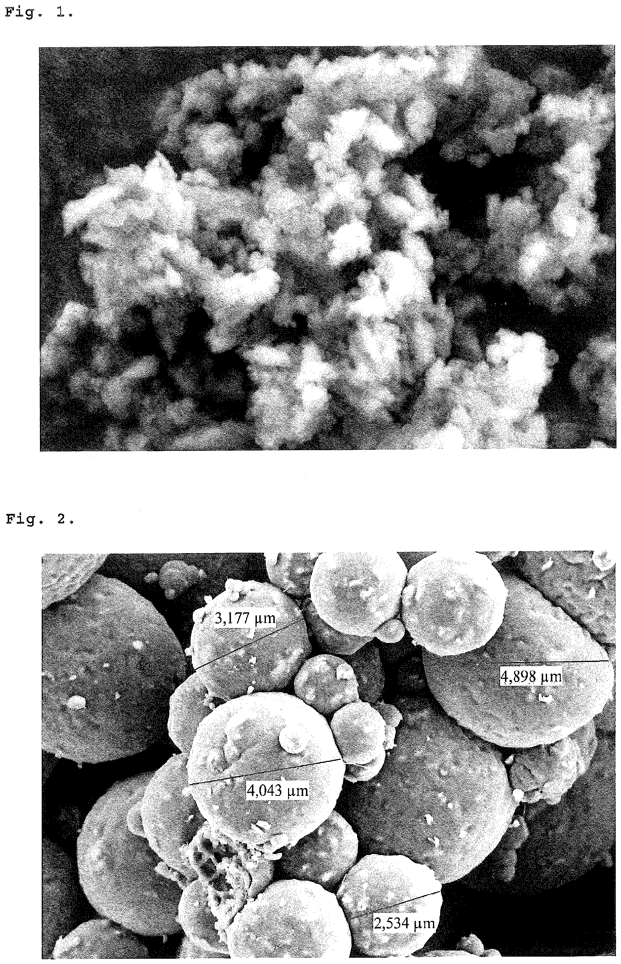

Fig. 1. zeigt eine REM-Aufnahme der mit Polyacrylsäure-beschichteten Silicium-Nanopartikel gemäß Beispiel 1 in 30.000facher Vergrößerung. Die ursprüngliche, splittrige Struktur der Silicium-Nanopartikel ist nach wie vor zu erkennen, die weichen Oberflächen und Kanten belegen eine gleichförmige, homogene Polymerbeschichtung.

Zusammensetzung des unbeschichteten Ausgangsmaterials: C 2,1 Gew-%; O 4,4 Gew-%; N 0,2 Gew-%; H 0,5 Gew-%; Polymergehalt (TGA): 49 Gew-%.

Fig. 1. zeigt eine REM-Aufnahme der mit Polyacrylsäure-beschichteten Silicium-Nanopartikel gemäß Beispiel 1 in 30.000facher Vergrößerung. Die ursprüngliche, splittrige Struktur der Silicium-Nanopartikel ist nach wie vor zu erkennen, die weichen Oberflächen und Kanten belegen eine gleichförmige, homogene Polymerbeschichtung.

### Beispiel 2:

### Einbettung von polymerbeschichteten Silicium-Nanopartikeln in einen Kohlenstoff-Precursor (Polyacrylnitril):

Polymer-beschichtetes Silicium-Nanopulver (27,6 g; enthaltend 3,6 g Silicium und 24 g Polyethylenoxid-Polypropylenoxid-Copolymer (Pluronic P123®)) wurde in einer Lösung aus 48 g Polyacrylnitril (PAN) in 3200 ml DMF mittels Ultraschall dispergiert (Hielscher UIS250V; Amplitude 80%, Cycle: 0,9; Dauer: 30 min). Die resultierende Dispersion wurde mit einem Laborsprühtrockner vom Typ B-290 (BÜCHI GmbH) mit Inertloop B-295 und Entfeuchter B-296 (BÜCHI GmbH) versprüht und getrocknet (Düsenspitze 0,7 mm; Düsenkappe 1,4 mm; Düsentemperatur 180 °C; N₂-Gasfluss 30; Aspirator 100%; Pumpe 20%).

Es wurden 64,8 g eines feinen, braunen Pulvers (Präkomposit) erhalten (Ausbeute 86%).

### Beispiel 3:

### Carbonisierung eines Präkomposits:

31,3 g des in Beispiel 2 erhaltenen Präkomposits wurden in ein Quarzglasschiffchen (QCS GmbH) gegeben und in einem Drei-Zonen-Rohrofen (TFZ 12/65/550/E301; Carbolite GmbH) unter Verwendung einer Kaskadenregelung inklusive eines Probenelements Typ N mit Argon/H₂ als Inertgas carbonisiert: Zuerst Heizrate 10 °C/min, Temperatur 300 °C, Haltedauer 90 min, Ar/H₂-Flussrate 200 ml/min; danach direkt weiter mit Heizrate 10 °C/min, Temperatur 1000 °C, Haltedauer 3 h, Ar/H₂-Flussrate 200 ml/min. Nach dem Abkühlen wurden 9,00 g eines schwarzen Pulvers erhalten (Carbonisierungsausbeute 29%), welches mittels Nasssiebung von Überkorn befreit wurde. Es wurden 3,89 g poröse Komposit-Partikel mit einer Partikelgröße von d₉₉ < 20 µm erhalten. Elementare Zusammensetzung: Si 15,8 Gew-%; C 75,2 Gew.-%; O 4,58 Gew-%; N 4,25 Gew-%; B <50 ppm; P 200 ppm; Al <50 ppm; Ca <50 ppm; Cu < 10 ppm; K 340 ppm; Li<10 ppm; Zr 720 ppm; Partikelgrößenverteilung: Monomodal; d₁₀: 8,03 µm, d₅₀: 13,6 µm, d₉₀: 20,9 µm; (d₉₀-d₁₀)/d₅₀ = 0,95;
Spez. Oberfläche (BET) = 23,1 m²/g;
Si-Dichtigkeit: 92,4% (nicht flüssigkeitsdicht);
Theoretische Kapazität: 573 mAh/g.

### Beispiel 4:

### Beschichtung eines porösen Komposits mit einem dichten Kohlenstoff-Film basierend auf Pech-Precursoren:

3,89 g der in Beispiel 3 erhaltenen porösen Komposit-Partikel wurden zusammen mit 630 mg Pech (hochschmelzend; Erweichungspunkt 235 °C) in 60 ml p-Xylol mittels Ultraschall (Hielscher UIS250V; Amplitude 80%, Cycle: 0,9; Dauer: 30 min) dispergiert. Die Suspension wurde 90 min unter Rückfluss gerührt und innerhalb von 14 h auf Raumtemperatur abgekühlt. Das Lösungsmittel wurde unter vermindertem Druck entfernt, und die Pech-beschichteten Komposit-Partikel wurden in ein Quarzglasschiffchen (QCS GmbH) überführt und unter Verwendung einer Kaskadenregelung inklusive eines Probenelements Typ N mit Argon/H₂ als Inertgas carbonisiert: Zuerst Heizrate 10 °C/min, Temperatur 250 °C; danach direkt weiter mit Heizrate 5 °C/min, Temperatur 550 °C; danach direkt weiter mit 10 °C/min, 1000 °C, Haltedauer 2 h, Ar/H₂-Flussrate 200 ml/min. Nach dem Abkühlen wurden 3,99 g eines schwarzen Pulvers erhalten (Carbonisierungsausbeute 88%), welches mittels Nasssiebung von Überkorn befreit wurde. Es wurden 3,06 g poröse Si/C-Komposit-Partikel mit dichter äußerer C-Beschichtung und mit einer Partikelgröße von d₉₉ < 20 µm erhalten.

Elementare Zusammensetzung: Si 13,2 Gew-%; C 79,4 Gew.-%; O 3,58 Gew-%; N 3,79 Gew-%; B <50 ppm; P <200 ppm; Al <50 ppm; Ca <50 ppm; Cu <10 ppm; K 342 ppm; Li<10 ppm; Zr 669 ppm; Partikelgrößenverteilung: Monomodal; d₁₀: 7,92 µm, d₅₀: 12,9 µm, d₉₀: 19,6 µm; (d₉₀-d₁₀)/d₅₀ = 0,91;
Spez. Oberfläche (BET) = 2,2 m²/g;
Si-Dichtigkeit: 97,7% (flüssigkeitsdicht);
Theoretische Kapazität: 506 mAh/g.

Fig. 2 zeigt das REM-Bild des in Beispiel 4 erhaltenen Si/C-Komposit-Partikels (7.500-fache Vergrößerung). Die Oberfläche ist glatt und geschlossen und somit flüssigkeitsdicht.

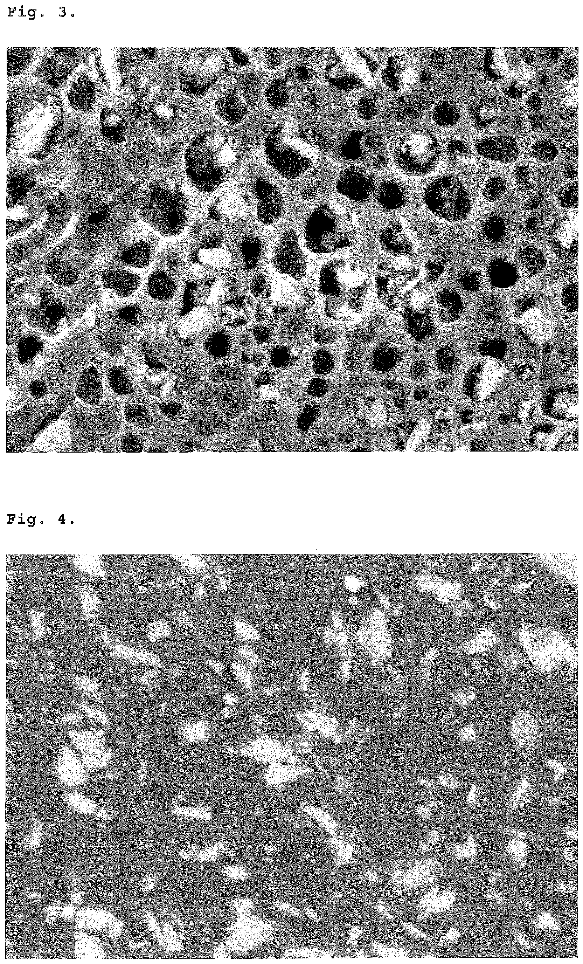

Fig. 3 zeigt einen REM-Schnitt durch einen Si/C-Komposit-Partikel aus Beispiel 4 (30.000-fache Vergrößerung). Die Silicium-Partikel sind in lokale Makroporenräume eingebettet, welche die Silicium-Volumenausdehnung beim Beladen entsprechender Lithium-Ionen-Batterien abpuffern können.

### Vergleichsbeispiel 5:

Fig. 4 zeigt einen REM-Schnitt durch ein unporöses Si/C-Komposit, das in Anlehnung an die Beispiele 2-4, jedoch ohne Einsatz des Porenbildners Pluronic hergestellt wurde (30.000-fache Vergrößerung). Die Silicium-Partikel sind hier ohne lokale Makroporen in eine C-Matrix eingebettet und besitzen kein Leervolumen zur Abpufferung der Si-Volumenausdehnung beim Beladen entsprechender Lithium-Ionen-Batterien.

## Patentansprüche

1. Verfahren zur Herstellung von Si/C-Kompositpartikeln durch
a) Beschichten von Siliciumpartikeln mit einem oder mehreren organischen oder anorganischen Opfermaterialien ausgewählt aus der Gruppe umfassend Oxide, Carbonate, Carbide, Nitride oder Sulfide der Elemente Magnesium, Calcium, Zinn, Zink, Titan oder Nickel; Polyethylen; Polypropylen; Polystyrol; Polybutadien; Poly-tert-Butoxystyrol; Polyvinylchlorid; Polyvinylacetat; Polymethacrylmethacrylat; Polyacrylsäure; Polymethacrylat; Polyvinylstearat; Polyvinyllaurat; Polyvinylalkohol; Alkylenglycole; Polyalkylenoxide; Gamma-Butyrolacton; Propylencarbonat; Polyurethane; und Stickstoff-haltige Lösungsmittel,
b) Beschichten der Produkte aus Stufe a) mit einem oder mehreren organischen Kohlenstoff-Precursoren, ausgewählt aus der Gruppe umfassend Resorcin-Formaldehyd-Harz, Lignin und Polyacrylnitril, unter Bildung von Präkompositen,
c) thermische Behandlung der Präkomposite aus Stufe b), wobei die in Stufe b) hergestellte Beschichtung basierend auf organischen Kohlenstoff-Precursoren carbonisiert und das organische oder anorganische Opfermaterial aus den Präkompositen teilweise oder vollständig freigesetzt wird unter Bildung von porösen Kompositen und
d) Beschichten der porösen Komposite aus Stufe c) mit einer oder mehreren Kohlenstoff-Beschichtungen, was zu den Si/C-Kompositpartikeln führt.

2. Verfahren zur Herstellung von Si/C-Kompositpartikeln gemäß Anspruch 1, **dadurch gekennzeichnet, dass**
die organischen Opfermaterialien ausgewählt werden aus der Gruppe umfassend Polyethylen, Polystyrol, Polyacrylmethacrylat, Polyethylenoxid, Polypropylenoxid und Polyethylenoxid-Polypropylenoxid-Copolymere .

3. Verfahren zur Herstellung von Si/C-Kompositpartikeln gemäß Anspruch 1 oder 2, **dadurch gekennzeichnet, dass**
als Kohlenstoff-Precursor der Stufe b) Polyacrylnitril eingesetzt wird.

4. Verfahren zur Herstellung von Si/C-Kompositpartikeln gemäß Anspruch 1 bis 3, **dadurch gekennzeichnet, dass**
die in Stufe c) gebildeten porösen Komposite Poren enthalten, in denen sich Siliciumpartikel befinden.

5. Verfahren zur Herstellung von Si/C-Kompositpartikeln gemäß Anspruch 4, **dadurch gekennzeichnet, dass**
die Poren, die Siliciumpartikel enthalten, Durchmesser von 60 nm bis 1400 nm haben, wobei die Bestimmungsmethode Raster-Elektronen-Mikroskopie ist.

6. Verfahren zur Herstellung von Si/C-Kompositpartikeln gemäß Anspruch 1 bis 5, **dadurch gekennzeichnet, dass**
in Stufe d) die porösen Komposite der Stufe c) zunächst mit einer oder mehreren Kohlenstoff-Vorstufen α) beschichtet werden und
anschließend die so aufgebrachten Kohlenstoff-Vorstufen α) durch thermische Behandlung carbonisiert werden,
wobei die Kohlenstoff-Vorstufen α) ausgewählt werden aus der Gruppe umfassend Teere, Peche, HardCarbon und SoftCarbon.

7. Verfahren zur Herstellung von Si/C-Kompositpartikeln gemäß Anspruch 1 bis 5, **dadurch gekennzeichnet, dass**
in Stufe d) die porösen Komposite der Stufe c) mittels chemischer Gasphasenabscheidung unter Einsatz von Kohlenstoff-Vorstufen β) mit Kohlenstoff beschichtet werden,
wobei die Kohlenstoff-Vorstufen β) ausgewählt werden aus der Gruppe umfassend aliphatische Kohlenwasserstoffe mit 1 bis 10 Kohlenstoffatomen; ungesättigte Kohlenwasserstoffe mit 1 bis 4 Kohlenstoffatomen; und aromatische Kohlenwasserstoffe.

8. Verfahren zur Herstellung von Si/C-Kompositpartikeln gemäß Anspruch 1 bis 7, **dadurch gekennzeichnet, dass**
die in Stufe d) aufgebrachte Kohlenstoff-Beschichtung der Si/C-Kompositpartikel eine Porosität von ≤ 2% hat, wobei die Porosität nach der folgenden Methode berechnet wird: 1 minus der Quotient aus der Rohdichte und der Skelettdichte, wobei die Rohdichte mittels Xylol-Pyknometrie gemäß DIN 51901 und die Skelettdichte mittels He-Pyknometrie gemäß DIN 66137-2 bestimmt werden.

9. Si/C-Kompositpartikel erhältlich nach den Verfahren der Ansprüche 1 bis 8, mit der Maßgabe, dass sich ≥ 80% der Siliciumpartikel, bezogen auf die Gesamtzahl der Siliciumpartikel, in Poren der porösen Komposite der Stufe c) befinden, wobei die Bestimmungsmethode Raster-Elektronen-Mikroskopie ist.

10. Verwendung der Si/C-Kompositpartikel aus Anspruch 9 in Elektrodenmaterialien für Lithiumionen-Batterien.

## Claims

1. Method for producing Si/C composite particles by
a) coating silicon particles with one or more sacrificial organic or inorganic materials selected from the group encompassing oxides, carbonates, carbides, nitrides or sulfides of the elements magnesium, calcium, tin, zinc, titanium or nickel; polyethylene; polypropylene; polystyrene; polybutadiene; poly-tert-butoxystyrene; polyvinyl chloride; polyvinyl acetate; polymethacryl methacrylate; polyacrylic acid; polymethacrylate; polyvinyl stearate; polyvinyl laurate; polyvinyl alcohol; alkylene glycols; polyalkylene oxides; gamma-butyrolactone; propylene carbonate; polyurethanes; and nitrogen-containing solvents,
b) coating the products from stage a) with one or more organic carbon precursors, selected from the group encompassing resorcinol-formaldehyde resin, lignin, and polyacrylonitrile, to form precomposites,
c) thermally treating the precomposites from stage b), where the coating produced in stage b) and based on organic carbon precursors is carbonized and the sacrificial organic or inorganic material is released partly or wholly from the precomposites, to form porous composites, and
d) coating the porous composites from stage c) with one or more carbon coatings, leading to the Si/C composite particles.

2. Method for producing Si/C composite particles according to Claim 1, **characterized in that**
the sacrificial organic materials are selected from the group encompassing polyethylene, polystyrene, polyacryl methacrylate, polyethylene oxide, polypropylene oxide, and polyethylene oxide-polypropylene oxide copolymers.

3. Method for producing Si/C composite particles according to Claim 1 or 2, **characterized in that** polyacrylonitrile is used as carbon precursor of stage b) .

4. Method for producing Si/C composite particles according to Claim 1 to 3, **characterized in that**
the porous composites formed in stage c) comprise pores in which there are silicon particles.

5. Method for producing Si/C composite particles according to Claim 4, **characterized in that**
the pores which comprise silicon particles have diameters of 60 nm to 1400 nm, where the method of determination is scanning electron microscopy.

6. Method for producing Si/C composite particles according to Claim 1 to 5, **characterized in that**
in stage d), the porous composites of stage c) are first coated with one or more carbon precursors α), and subsequently the carbon precursors α) thus applied are carbonized by thermal treatment,
where the carbon precursors α) are selected from the group encompassing tars, pitches, hard carbon, and soft carbon.

7. Method for producing Si/C composite particles according to Claim 1 to 5, **characterized in that**
in stage d), the porous composites of stage c) are coated with carbon by means of chemical vapor deposition using carbon precursors β),
where the carbon precursors β) are selected from the group encompassing aliphatic hydrocarbons having 1 to 10 carbon atoms; unsaturated hydrocarbons having 1 to 4 carbon atoms; and aromatic hydrocarbons.

8. Method for producing Si/C composite particles according to Claim 1 to 7, **characterized in that**
the carbon coating on the Si/C composite particles that is applied in stage d) has a porosity of ≤ 2%, where the porosity is calculated according to the following method: 1 minus the ratio of the apparent density and the skeletal density, where the apparent density is determined by means of xylene pycnometry in accordance with DIN 51901 and the skeletal density is determined by means of He pycnometry in accordance with DIN 66137-2.

9. Si/C composite particles obtainable by the methods of Claims 1 to 8, with the proviso that ≥ 80% of the silicon particles, based on the total number of silicon particles, are located in pores of the porous composites of stage c), where the method of determination is scanning electron microscopy.

10. Use of the Si/C composite particles from Claim 9 in electrode materials for lithium-ion batteries.

## Revendications

1. Procédé de fabrication de particules composites Si/C par :
a) revêtement de particules de silicium avec un ou plusieurs matériaux sacrificiels organiques ou inorganiques choisis dans le groupe comprenant les oxydes, les carbonates, les carbures, les nitrures ou les sulfures des éléments magnésium, calcium, étain, zinc, titane ou nickel ; le polyéthylène ; le polypropylène ; le polystyrène ; le polybutadiène ; le poly-tert-butoxystyrène ; le polychlorure de vinyle ; le polyacétate de vinyle ; le polyméthacrylate de méthacryle ; l'acide polyacrylique ; le polyméthacrylate ; le polystéarate de vinyle ; le polylaurate de vinyle ; l'alcool polyvinylique ; les alkylène glycols ; les polyoxydes d'alkylène ; la gamma-butyrolactone ; le carbonate de propylène ; les polyuréthanes ; et les solvants contenant de l'azote,
b) revêtement des produits de l'étape a) avec un ou plusieurs précurseurs organiques de carbone, choisis dans le groupe comprenant la résine résorcine-formaldéhyde, la lignine et le polyacrylonitrile, pour former des précomposites,
c) traitement thermique des précomposites de l'étape b), le revêtement réalisé à l'étape b) à base de précurseurs organiques de carbone étant carbonisé, et le matériau sacrificiel organique ou inorganique étant dégagé en partie ou en totalité des précomposites pour former des composites poreux, et
d) revêtement des composites poreux de l'étape c) avec un ou plusieurs revêtements de carbone, ce qui conduit aux particules composites Si/C.

2. Procédé de fabrication de particules composites Si/C selon la revendication 1, **caractérisé en ce que** les matériaux sacrificiels organiques sont choisis dans le groupe comprenant le polyéthylène, le polystyrène, le polyméthacrylate d'acryle, le polyoxyde d'éthylène, le polyoxyde de propylène et les copolymères de polyoxyde d'éthylène-polyoxyde de propylène.

3. Procédé de fabrication de particules composites Si/C selon la revendication 1 ou 2, **caractérisé en ce que** du polyacrylonitrile est utilisé en tant que précurseur de carbone de l'étape b).

4. Procédé de fabrication de particules composites Si/C selon les revendications 1 à 3, **caractérisé en ce que** les composites poreux formés à l'étape c) contiennent des pores dans lesquels se trouvent des particules de silicium.

5. Procédé de fabrication de particules composites Si/C selon la revendication 4, **caractérisé en ce que** les pores qui contiennent des particules de silicium ont un diamètre de 60 nm à 1 400 nm, la méthode de détermination étant la microscopie électronique à balayage.

6. Procédé de fabrication de particules composites Si/C selon les revendications 1 à 5, **caractérisé en ce qu'**à l'étape d), les composites poreux de l'étape c) sont tout d'abord revêtus avec un ou plusieurs précurseurs de carbone α), puis
les précurseurs de carbone α) ainsi appliqués sont carbonisés par traitement thermique,
les précurseurs de carbone α) étant choisis dans le groupe comprenant les goudrons, les brais, le carbone dur et le carbone doux.

7. Procédé de fabrication de particules composites Si/C selon les revendications 1 à 5, **caractérisé en ce qu'**à l'étape d), les composites poreux de l'étape c) sont revêtus avec du carbone par dépôt chimique en phase vapeur en utilisant des précurseurs de carbone β),
les précurseurs de carbone β) étant choisis dans le groupe comprenant les hydrocarbures aliphatiques de 1 à 10 atomes de carbone ; les hydrocarbures insaturés de 1 à 4 atomes de carbone ; et les hydrocarbures aromatiques.

8. Procédé de fabrication de particules composites Si/C selon les revendications 1 à 7, **caractérisé en ce que** le revêtement de carbone des particules composites Si/C appliqué à l'étape d) présente une porosité ≤ 2 %, la porosité étant calculée par la méthode suivante : 1 moins le quotient de la densité apparente et de la densité réelle, la densité apparente étant déterminée par pycnométrie au xylène selon DIN 51901 et la densité réelle étant déterminée par pycnométrie à He selon DIN 66137-2.

9. Particules composites Si/C pouvant être obtenues par le procédé selon les revendications 1 à 8, à condition que ≥ 80 % des particules de silicium, par rapport au nombre total de particules de silicium, se trouvent dans des pores des composites poreux de l'étape c), la méthode de détermination étant la microscopie électronique à balayage.

10. Utilisation des particules composites Si/C selon la revendication 9 dans des matériaux d'électrode pour des batteries lithium-ion.
